Europäisches Patentamt

European Patent Office

Office européen des brevets

(19)

(11) Publication number: 0 402 896
A2

# (12) EUROPEAN PATENT APPLICATION

(21) Application number: 90111194.8

(51) Int. Cl.5: C25D 3/38

(22) Date of filing: 13.06.90

(30) Priority: 13.06.89 GB 8913561

(43) Date of publication of application:
19.12.90 Bulletin 90/51

(84) Designated Contracting States:
CH DE FR GB LI

(71) Applicant: LeaRonal (UK) plc
High Peak Laboratories Ashbourne Road
Buxton Derbyshire SK17 9SS(GB)

(72) Inventor: Withlaw, Keith John
94 Green Lane
Buxton, Derbyshire(GB)
Inventor: Brookes, David Glynne
118 St. John's Road
Buxton, Derbyshire(GB)

(74) Representative: Avery, Stephen John et al
Hoffmann, Eitle & Partner Arabellastrasse 4
D-8000 München 81(DE)

(54) Method of stabilising an organic additive in an acid copper electroplating solution.

(57) An acid copper electroplating solution comprising an organic additive is stabilised by including a transition metal in an amount of not more than 5 g/l, the transition metal being capable of existing in at least two positive oxidation states, but being substantially present in its lowest common positive oxidation state, in the solution.

The organic additive may comprise at least one grain refiner, which may act as a brightener. The transition metal may be selected from at least one of $Mn^{2+}$, $Fe^{2+}$, $Cr^{2+}$ and $Ti^{2+}$.

The electroplating solution may be one from the Copper Gleam 125 series marketed by LeaRonal.

EP 0 402 896 A2

# METHOD OF STABILISING AN ORGANIC ADDITIVE IN AN ACID COPPER ELECTROPLATING SOLUTION

The present invention relates to a method of stabilising an organic additive in an acid copper electroplating solution.

Acid copper electroplating solutions are used in the manufacture of printed circuit boards. These boards have become very important commercially, since they are used in almost every area of the electronics industry and form an important part of almost every electronic device that is manufactured.

A printed circuit board is prepared from a precursor board consisting of a dielectric sheet or board having a thin layer of copper laminated to both of its major surfaces. Holes are drilled through the thickness of the precursor board to accommodate the leads of various electronic components which are attached to it at a later stage. The plastic wall of the hole, which is exposed by the drilling, must be made conductive in order to establish an electrically conductive path between the copper laminates. This is accomplished by initially carrying out a chemical process known as metallization during which a thin copper layer is deposited on the hole wall surface.

Since the copper layer formed by the metallizing process is generally too thin to form a suitable conductive path between the copper laminates, an additional step of copper electroplating is used to thicken the layer of copper on the hole wall surface in order to form a conductive path having a sufficient cross-section to carry electrical current.

The solution for carrying out this copper electroplating is an aqueous solution including several organic additives such as a grain refiner. The electroplating process is plagued with excessive consumption of the organic additives, and especially the grain refiner. These problems have been attributed to large anode areas and the use of titanium baskets.

The prior art has been unable to suggest a long term solution to this problem. It is an object of the present invention to reduce the consumption of organic additives in an acid copper electroplating solution.

In the description and claims which follow, amounts indicated in g/l of a transition metal salt are in terms of the amount of metal unless otherwise indicated.

According to one aspect, the present invention provides an acid copper electroplating solution comprising at least one organic additive and a transition metal in an amount of not more than 5 g/l, the transition metal being capable of existing in at least two positive oxidation states, but being substantially present in the solution in its lowest common positive oxidation state.

It has surprisingly been found that the presence of the transition metal in its lowest common positive oxidation state helps to stabilise the organic additive.

Preferably, the organic additive comprises at least one grain refiner, which may act as e.g. a brightener. Examples of the organic additives are mercapto propane sulphonic acid, bis(propane-3-sulphonic acid) disulphide, N,N-dimethyl dithiocarbamic acid - (3-sulphopropyl)-ester, and the reaction products of sulphur containing compounds as exemplified by US patent number 4490220 (December 25 1984 assigned to LeaRonal Inc Freeport).

Preferably the transition metal capable of existing in at least two positive oxidation states, but substantially present in its lowest oxidation state, is selected from at least one of $Mn^{2+}$, $Fe^{2+}$, $Cr^{2+}$ and $Ti^{2+}$.

The acid copper electroplating solution may be one selected from the Copper Gleam 125 series marketed by LeaRonal.

It is preferred that the various carrier and additive solutions for preparing and later adding to the electroplating baths commonly used to carry out electroplating should include the transition metal in the appropriate oxidation state. In the case of manganese, this may be as hydrated manganese sulphate ($MnSO_4.H_2O$ or $MnSO_4.4H_2O$).

According to a second aspect, the present invention provides the use of a transition metal capable of existing in at least two positive oxidation states, but being substantially present in its lowest common positive oxidation state, for stabilising an organic additive in an acid copper electroplating solution.

In a preferred use, the transition metal is selected from at least one of the transition metals listed above, and is preferably added to the solution in the form of a salt.

It is also possible to incorporate the required transition metal into the electroplating solution by carrying out purification of an aged solution with for example potassium permanganate. Accordingly, a third aspect of the present invention provides a method of stabilising an organic additive in an acid copper electroplating solution comprising the step of adding a permanganate salt to the solution to decontaminate it from adventitious impurities, the permanganate salt being reduced during the decontamination to $Mn^{2+}$ ions which stabilise the organic additive.

In-tank potassium permanganate purification may be carried out by adding potassium permanganate to the electroplating solution without removing the anodes and allowing it to decolourise itself without the addition of carbon or hydrogen peroxide.

It is preferred that the electroplating solution comprises 0.1-5 g/l of manganese, more preferably, 0.5-2.0 g/l, and most preferably 0.7-1.0g/l to stabilise the organic additive.

It has been found that the presence of the transition metal within the upper concentration limit of the present invention has no detrimental effect on the performance of the electroplating solution or on the properties of the metal layer which is deposited.

The dilution Hull cell technique has proved useful in predicting additive concentration and consumption. CVS analysis has also been used. In some circumstances however, CVS analysis may be affected by the presence of the transition metal ions.

The following provides a description of the preferred embodiments of the present invention.

Experiments were conducted using a 10 x dilution Hull cell technique to determine the appropriate amount of transition metal to be added. Consumption of the organic additives was determined by bubbling air through a sample of the solution over night in the presence of a copper/titanium couple and brightener content measured the following day by a Hull cell technique (both diluted and undiluted). Tests were also carried out on both new and aged electroplating solutions both in the presence and absence of appropriate transition metals. Both new and aged solutions lacking a transition metal as a stabiliser were found to be dull (undiluted) after overnight testing. However, when 1 g/l of $Mn^{2+}$ ions were added to both the aged and new solutions, then both solutions were found to be bright (undiluted) and partially bright (ten times diluted). The same effect was observed when the manganese was added as a salt (e.g. manganese sulphate) or as potassium permanganate followed by decolourisation with or without the addition of hydrogen peroxide. Details of these tests are provided in the following Example 1. Copper Gleam 125 LX Additive and Carrier are products of LeaRonal.

Example 1

Consecutive Hull Cell Tests: 2 amps, 10 mins, 25°C, air agitation.

1. New Copper Gleam 125LX: 15 fully bright consecutive Hull cell panels were produced.
2. New Copper Gleam 125LX at 1 ml/l additive: 12 fully bright consecutive Hull cell panels were produced.
3. Aged solution with additive increased to 2 ml/l: 12 fully bright consecutive Hull cell panels were produced.

Dilution Hull Cell Tests: 2 amps, 10 mins, 25°C, air agitation.

The following solutions were diluted 5x using calibration solution (working solution without additive but with 16ml/l carrier).
1. Control - new Copper Gleam 125LX : bright 0-10 amp/dm².
2. Aged solution : semi-bright 0-1.5 amp/dm² (i.e. 0.5 ml/l additive).
3. As 2, additive increased to 2 ml/l : bright 0-10 amp/dm².
4. As 3, carbon/hydrogen peroxide treated using 1 ml/l hydrogen peroxide (100 vol) for 30 mins and 2 g/l carbon for 1 hour at 60°C, solution filtered + 2ml/l₂ Copper Gleam 125LX additive : bright 0-10 amp/dm².
5. As 3 + 3 g/l potassium permanganate at 45°C for 1 hour, solution cooled to 25°C + 2 ml/l Copper Gleam 125LX additive : bright O-10 amp/dm².

Passive Loss of Additive Tests

The undiluted solutions from the above tests were left overnight with a copper/titanium couple with air agitation and Hull cells repeated the following morning on undiluted samples.
1. Copper Gleam 125LX control - dull over whole panel.
2. Aged solution with additive content raised to 2 ml/l - dull over whole panel.
3. As solution 2 carbon/hydrogen peroxide treated - dull over whole panel.
4. As solution 2 potassium permanganate treated -fully bright 0-10 amp/dm².

3

5. Copper Gleam 125LX - new solution + 3.2 g/l manganese sulphate - bright 0-10 amp/dm$^2$.

Consecutive Hull cell tests were carried out on solution 5 and more than 26 fully bright panels were produced.

Tests were also carried out on new solutions to determine the optimum manganese and carrier concentrations. The results of these tests are provided in the following Example 2. The preferred concentration of manganese is 0.1 - 5 g/l in the form of e.g. manganese sulphate.

## Example 2

Tests were carried out to determine the optimum content of manganese sulphate.

Overnight tests with a copper/titanium couple and air agitation were carried out followed by Hull cell tests at 2 amp, 10 mins, 25°C, with air agitation.

1. Copper Gleam 125LX - control - no manganese undiluted - dull over whole panel.
2. As 1 + 0.032 g/l manganese sulphate undiluted - dull over whole panel.
3. As 1 + 0.16 g/l manganese sulphate undiluted - hazy bright 2.5 cms 5 x diluted - dull over whole panel.
4. As 1 + 0.32 g/l manganese sulphate 10 x diluted - bright 3 cms
5. As 1 + 0.96 g/l manganese sulphate 10 x diluted - bright 3.5 cms
6. As 1 + 3.2 g/l manganese sulphate 10 x diluted - bright 4 cms

Consecutive Hull cell tests were carried out on solutions with 7 ml/l and 16 ml/l carrier content to determine the optimum level.

1. 2 ml/l Copper Gleam 125LX Additive + 7 ml/l 125LX Carrier, no manganese - gave 11 fully bright consecutive panels.
2. 2 ml/l Copper Gleam 125LX Additive + 16 ml/l 125LX Carrier, no manganese - gave 16 fully bright consecutive panels.
3. As 1 + 0.32 g/l manganese sulphate - was still bright after 21 consecutive panels.
4. As 2 + 0.32 g/l manganese sulphate - was still bright after 21 consecutive panels.

Copper Gleam 125LX Carrier was also tested containing 20 g/l manganese sulphate (0.32 g/l manganese sulphate in the working solution).

## Hull Cell Tests 2 amp, 10 mins, 25°C, air agitation.

1. 2 ml/l Copper Gleam 125LX additive + 16 ml/l 125LX carrier (containing manganese)
10 x dilution - bright 8.7 cms
20 x dilution - bright 4 cms.
2. After air/copper/titanium overnight -undiluted - bright panel.

Tests were also carried out to determine the effect of the presence of manganese on solution performance and deposit properties. The results of these tests are provided in the following Example 3. It will be apparent that no adverse effects were uncovered.

## Example 3

Quality control tests were carried out on Copper Gleam 125LX containing manganese to determine the effects.

## Levelling. 2 amp/dm$^2$, 70 mins, 25°C, air agitation.

A high aspect ratio board was plated in Copper Gleam 125LX + 3.2 g/l manganese sulphate. This was microsectioned and inspected for levelling.

1. Good levelling.

## Distribution

4

The HARB from the levelling test was used to measure distribution
Average thickness on surface 21.4 microns
Average thickness down hole 15.9 microns.
Distribution - ratio surface: down hole 1.35:1.

Thermal Shock. 2.5 amp/dm², 1 hour rotary agitation 25°C, thermal shock tested at 288°C for 10 secs.

1. Copper Gleam 125LX + 3.2 g/l manganese sulphate - no cracks on corners.

Hull Cell Test 25°C air agitation.

1. 2 amp 10 mins - fully bright 0-9 amp/dm².
2. Followed by 0.5 amps 30 mins - fully bright over whole panel.

Manganese Content in the Deposit

A piece of foil was plated in Copper Gleam 125LX + 3.2 g/l manganese sulphate, this was dissolved and analysed by AAS. Manganese content in deposit 0.003%.

Long term electrolysis consumption tests were carried out using solutions with and and without manganese ions and the results are provided in the following Example 4.

Example 4

Consumption tests were carried out on Copper Gleam 125LX with and without manganese. 4 litre samples were tested using copper chip anodes in titanium baskets. The solutions were previously 'dummied' at 1 amp/dm² for 2 hours with carrier but without additive or manganese. Analysis was carried out by Hull cell technique in the morning, adjusted to 2 ml/l and run all day with hourly replenishment at 0.3 ml/ampere hour. Analysis was repeated at night and the additive re-adjusted to 2 ml/l. The solutions were left idle overnight without air agitation.

| Standard Copper Gleam 125LX | Copper Gleam 125LX + 3.2 g/l manganese sulphate |
|---|---|
| Day 1 | Day 1 |
| Solution run for 7.2 A/H<br>Total replenishment added 0.92 ml/AH | Solution run for 7.2A/H<br>Total replenishment added ml/AH 0.61 |
| Day 2 | Day 2 |
| Solution run for 21.6 A/H<br>Total rate of replenishment to date 0.66 ml/AH | Solution run for 21.6 A/H<br>Total rate of replenishment to date 0.45 ml/AH |
| Day 3 | Day 3 |
| Solution run for 21.6 A/H<br>Total rate of replenishment to date 0.73 ml/AH | Solution run for 21.6 A/H<br>Total rate of replenishment to date 0.49 ml/AH |
| Solutions stood idle over weekend | |
| Day 4 | Day 4 |
| Solution run for 18 A/H<br>Total rate of replenishment to date 0.79 ml/AH | Solution run for 18 A/H<br>Total rate of replenishment to date date 0.60 ml/AH |
| Day 5 | Day 5 |
| Solution run for 21.6 A/H<br>Total rate of replenishment to date 0.74 ml/AH | Solution run for 21.6 A/H<br>Total rate of replenishment to date 0.56 ml/AH |
| Day 6 | Day 6 |
| Solution run for 21.6 A/H<br>Total rate of replenishment to date 0.73 ml/AH | Solution run for 21.6 A/H<br>Total rate of replenishment to date 0.57 ml/AH |
| Total number of A/H for the six days is 111.6 | |

It will be seen that a reduction in brightener consumption was obtained in the case of solutions containing manganese. From the results it can be concluded that manganese ions significantly reduce passive loss of the organic additives.

Similar tests were conducted in which $Fe^{2+}$ (as for example ferrous sulphate) were used in place of $Mn^{2+}$ ions, and equally impressive and surprising results were obtained. For instance, 1 g/l of ferrous sulphate was added to Copper Gleam 125LX and tested overnight with a copper/titanium couple and air agitation. A Hull cell test using 2 Amps for 10 minutes and 25°C with air agitation on the undiluted solution produced a bright panel.

Even though the presence of transition metal ions such as $Mn^{2+}$ and $Fe^{2+}$ are important for brightness stability and carrier content, the higher levels of carrier (2500 ppm) are preferred.

Modified CVS, dilution Hull cell, and consecutive Hull cell tests provide results which correlate quite well. On testing an aged bath sample, if a 10 x diluted Hull cell is bright, a minimum of ten consecutive 2 amp ten minute panels can be achieved and values of approximately 2 ml/l are achieved with modified CVS, it is certain that the electroplating solution is in good condition. Of the three methods, the dilution Hull cell technique is preferred since it is cheap, fast, reproducible and reliable. Details of the dilution Hull cell method are provided in the following Example 5.

Example 5

PROVISION METHOD

Diluted Hull Cell technique for Copper Gleam 125L and LX
1. Dilute 25 ml from plating solution with 225 mls "Basis" solution.
2. Carry out 2 amp 10 minute Hull cell test at 27-30°C with air agitation.
3. Examine result.

4. Interpretation

When the additive content of the bath is 2 -2.5 ml/l, the maximum area of dullness in the high c.d should cover less than a quarter of the panel - approx 2 cm.

If dullness encroaches further, but remains in the top third - add 1 ml/l additive to working solution.

If panel is totally dull, add 2 ml/l additive to working solution, Basis Solution Make-up

80 g/l Copper Sulphate

110 ml/l Sulphuric Acid 1.84

10 ml/l 0.1N (0.IM) Hydrochloric Acid

15 ml/l 125 BL Carrier or 125L Corrector

In deionised water.

Check basis solution on 2 amp 10 min Hull cell. Must be dull all over.

The recommended method for in-tank potassium permanganate purification is provided in the following Example 6.

Example 6

Procedure for Permanganate Purification of Copper Gleam Solution

1. Remove anodes from solution.
2. Raise temperature to 40 - 45° C.
3. Ensure vigorous air agitation of solution.
4. Add 2 g/l potassium permanganate to tank (preferably dissolved in very hot water. Solid can be added by dissolution and reaction takes longer.)
5. Continue to agitate until solution returns to clear blue colour and remains so for I hour.
6. Allow to cool to operating temperature.
7. Return to anodes to tank.
8. Add 2.5 ml/l additive.
9. Solution now ready to use.

This purification process can be carried out without removing the anodes but it is preferred to remove them. The purification can also be carried out at room temperature (25° C) but higher temperatures of 40-45° C are preferred. The concentration of potassium permanganate is not critical and can vary between 1 and 3 g/l. It is recommended that permanganate purification be carried out after about 500 ampere hours per litre with pattern plating using aqueous resists, 1000 ampere hours per litre with pattern plating using solvent resists and 2000 ampere hours per litre with panel plating. Although not essential, filtration over carbon is recommended before replacing the anodes and adding further additives.

Although large anode areas, the use of small chips in titanium baskets and brightener oxidation from air agitation during idle periods are all causes and contributory factors towards excessive brightener consumption, it has been found that the use of appropriate low oxidation state transition metal ions such as $Mn^{2+}$ or $Fe^{2+}$ is a simple and commercially more acceptable technique of combating excessive consumption of organic additives such as brighteners than that of for instance rearranging the anodes.

**Claims**

1. An acid copper electroplating solution comprising at least one organic additive and a transition metal in an amount of not more than 5 g/l, the transition metal being capable of existing in at least two positive oxidation states, but being substantially present in the solution in its lowest common positive oxidation state.

2. An electroplating solution according to claim 1 wherein the organic additive comprises at least one grain refiner.

3. An electroplating solution according to claim 1 or claim 2 wherein the transition metal is selected from at least one of $Mn^{2+}$, $Fe^{2+}$, $Cr^{2+}$ and $Ti^{2+}$.

4. The use of a transition metal capable of existing in at least two positive oxidation states, but being substantially present in its lowest common positive oxidation state, for stabilising an organic additive in an acid copper electroplating solution.

5. The use according to claim 4 wherein the transition metal is in the form of a salt.

6. The use according to claim 4 or claim 5 wherein the transition metal is selected from at least one of

7

$Mn^{2+}$, $Fe^{2+}$, $Cr^{2+}$ and $Ti^{2+}$.

7. A method of stabilising an organic additive in an acid copper electroplating solution comprising the step of adding a permanganate salt to the solution to decontaminate it from adventitious impurities, the permanganate salt being reduced during the decontamination to $Mn^{2+}$ ions which stabilise the organic additive.